# EUROPEAN PATENT APPLICATION

(11) **EP 1 229 155 A1**
(43) Date of publication of application: **07.08.2002**
(21) Application number: 01919881.1
(22) Date of filing: 10.04.2001
(51) Int. Cl.: C30B 29/06, H01L 21/20, H01L 21/205, H01L 21/322

(54) **SILICON WAFER, SILICON EPITAXIAL WAFER, ANNEAL WAFER AND METHOD FOR PRODUCING THEM**

(30) Priority: 14.04.2000 JP 2000113297
(71) Applicant: Shin-Etsu Handotai Co., Ltd, Tokyo 100-0005 (JP)
(72) Inventor: IIDA, Makoto, Annaka-shi, Gunma 379-0196 (JP); KIMURA, Masanori, Annaka-shi, Gunma 379-0196 (JP)
(74) Representative: Cooper, John
(86) International application number: JP0103101
(87) International publication number: WO0179593

(57) **Abstract**

The present invention relates to a method for producing a silicon single crystal pulled while doping with carbon and nitrogen and controlling to have an N-region over an entire plane of the crystal, and a silicon wafer doped with carbon and nitrogen and having an N-region over an entire plane. From this develops a growth technique of a silicon single crystal possible to grow a single crystal having few grown-in defects and high IG ability at a high growing rate, and there are provided a silicon wafer having an N-region over an entire plane of the crystal and high IG ability, an epitaxial wafer and an annealed wafer having excellent crystallinity and IG ability.

## Description

### Technical Field

The present invention relates to a high quality silicon wafer, epitaxial wafer and annealed wafer, and a method for producing the same effectively utilizing the affection of carbon and nitrogen doped in a CZ silicon single crystal.

### Background Art

With the higher integration and finer degree of a device process, silicon wafers used as substrates have strongly required the reduction of Grown-in defects. In this regard, several varieties of wafers having few grown-in defects have been developed, such as an entire N (Neutral)-region wafer developed by improving growth conditions of a CZ silicon single crystal produced in accordance with Czochralski (CZ) method, a silicon epitaxial wafer (hereinafter referred to an epitaxial wafer or epi-wafer) newly grown silicon on a conventional silicon wafer, and an annealed wafer subjected to a high temperature heat treatment in a hydrogen or argon atmosphere.

Here, there is provided the explanation about a method for producing an entire N-region wafer.

First, there is provided the explanation about common knowledge of each density determining factor of defects to be incorporated into a silicon single crystal, which are vacancy-type point defects called Vacancy (hereinafter occasionally abbreviated as V) and interstitial-silicon-type point defects called Interstitial-Si (hereinafter occasionally abbreviated as I).

In a silicon single crystal, a V-region is the region having large number of Vacancy, in other words, depressions or pits and the like generated due to lack of silicon atoms. An I-region is the region having large number of dislocations and agglomerates of excessive silicon atoms generated by the existence of excessive silicon atoms. Accordingly, between the V-region and the I-region, there exists a neutral region (hereinafter occasionally abbreviated as N-region) having no (little) lack or excess of atoms. It has been revealed that the aforementioned grown-in defects (FPD, LSTD, COP etc.) are generated only when V or I is supersaturated, and even if there is a little unevenness of atoms, I or V does not exist as the defects so long as V or I is not saturated.

It has been known that the densities of both point defects depend on the relationship between a crystal pulling rate (growing rate) V and a temperature gradient G in the vicinity of a solid-liquid interface in the crystal in the CZ method. It has been also confirmed that defects distributed in a ring shape called OSF (Oxidation Induced Stacking Fault) are present in the N-region between the V-region and the I-region.

The following is the classification of those defects generated due to the crystal growth. For example, when the growth rate is relatively high, i.e., around 0.6 mm/min or higher, grown-in defects considered to be originated from voids, i.e., aggregations of vacancy-type point defects, such as FPD, LSTD, and COP are distributed over the entire cross-section of the crystal along the radial direction at a high density, and a region containing such defects is called V-rich region. Further, when the growth rate is 0.6 mm/min or lower, the aforementioned OSF ring is initially generated at the circumferential part of the crystal with the decrease of the growth rate, and L/D (Large Dislocations, abbreviation of interstitial dislocation loops, which include LSEPD, LFPD and the like), which are considered to be originated from dislocation loops, i.e., aggregations of interstitial-silicon-type point defects, are present outside the ring at a low density, and a region containing such defects is called I-rich region. Furthermore, when the growth rate is further lowered to around 0.4 mm/min or lower, the OSF ring shrinks at the center of the wafer and disappears, and thus the entire plane becomes the I-rich region.

Recently, there has been discovered the existence of an N-region containing neither the void-originated FPD, LSTD, COP and the dislocation loop-originated LSEPD and LFPD nor OSF, and the region is present between the V-rich region and the I-rich region, and outside the OSF ring. This region exists outside the OSF ring, and shows substantially no oxygen precipitation when subjected to a heat treatment for oxygen precipitation and examined by X-ray analysis or the like as to the precipitation contrast. This region is present at rather I-rich side, and the defects are not so rich as to form LSEPD and LFPD. Further, there has been confirmed the existence of the N-region containing neither the void-originated defects and the dislocation loop-originated defects nor OSF, and the region is also present inside the OSF ring.

Because this N-region is obliquely formed toward the growing axis when the growth rate is lowered in a conventional growing method, it exists only in a part of a wafer plane.

With respect to the N-region, according to the Voronkov's theory (V.V. Voronkov, Journal of Crystal Growth, 59 (1982) 625-643), it was proposed that a parameter of V/G, which is a ratio of the pulling rate V and the crystal solid-liquid interface temperature gradient G along the growing axis, determined the total density of the point defect. In view of this, because the pulling rate should be constant in a plane, for example, a crystal having a V-rich region at the center, I-rich region at the periphery, and the N-region therebetween is inevitably obtained at a certain pulling rate due to the unevenness of the gradient G in the plane.

Therefore, improvement of such unevenness of the gradient G has recently been attempted, and it has become possible to produce a crystal having the N-region, which can previously exist only obliquely, spreading over an entire transverse cross-section of the crystal, for example, when the crystal is pulled with a gradually decreasing pulling rate V. Further, such an N-region spreading over an entire transverse cross-section can be made larger to some extent along the longitudinal direction of the crystal by pulling the crystal at a pulling rate maintained at a value at which the N-region transversely spreads. Furthermore, it has also become possible to make the N-region spreading over the entire transverse cross-section somewhat larger along the growing direction by controlling the pulling rate together with correction of G with reference to its variation with the crystal growth, so that the V/G should strictly be maintained constant.

Also, in order to eliminate the affection of impurities in a device process, wafers having high gettering ability have been required recently. In this regard, there have been developed wafers increasing BMD (Bulk Micro Defect: internal micro defects due to oxide precipitates) density in a bulk and having IG (Internal Gettering) effect produced by adding a heat treatment or utilizing oxygen precipitation accelerating effect of nitrogen such as a nitrogen-doped N-region wafer pulled in the N-region with doping with nitrogen during a silicon single crystal growth in accordance with CZ method, a nitrogen-doped epitaxial wafer performed an epitaxial growth on a nitrogen doped wafer, and a nitrogen-doped annealed wafer subjected a nitrogen-doped wafer to annealing.

Recently, the demand for gettering ability by device manufacturer has been very high, and it is indispensable for wafers to be used to have the gettering ability as an added value. However, in regard to conventional wafers such as an N-region wafer, epi-wafer and annealed wafer, each BMD density due to oxygen precipitation during a device process is hardly sufficient.

In view of this, the wafer doped with nitrogen, which utilizes oxygen precipitation accelerating effect of nitrogen, was developed. By doping with nitrogen, the range of the pulling rate possible to obtain an N-region is expanded, so that a stable crystal growth can be achieved. However, in order to produce the N-region wafer, its pulling rate is necessarily lowered about 0.5 mm/min, and it results in low productivity and high cost.

Further, if nitrogen concentration to be doped is increased, expansion of OSF region or generation of secondary defects (hereinafter occasionally referred to LEP (Large Etch Pit)) such as dislocation cluster in OSF region may occur. Those lead to defects in an epitaxial layer, and very high nitrogen concentration can not be employed in the present circumstances. As the result, the nitrogen-doped wafer has more BMD density than a nitrogen-non-doped wafer, but the density is moderately suppressed. The secondary defect in this regard is the defect generated in the OSF region expanded due to high concentration nitrogen doping, and of which typical example is a dislocation cluster (LEP) or dislocation loop.

Furthermore, it has been known that nitrogen can make stable oxygen precipitation nuclei in high temperature (Aihara et al., Extended Abstracts (The 46th Spring Meeting, 1999); The Japan Society of Applied Physics and Related Societies, No.1, page 461, 29a-ZB-5). However, nitrogen is not concerned with the formation of precipitation nuclei in low temperature, and therefore there is problem such that the acceleration of the formation of oxygen precipitation nuclei by low temperature heat treatment is unexpected or the like.

### Disclosure of the Invention

The present invention has been accomplished to solve the aforementioned problems, and its main object is to develop a silicon single crystal growing technique possible to grow a silicon single crystal having few grown-in defects and having high IG ability, and to provide a silicon wafer having high IG ability in an N-region for the entire plane of the crystal, an epitaxial wafer and an annealed wafer having excellent crystallinity and IG ability.

In order to solve the aforementioned problems, the present invention provides a method for producing a silicon single crystal, wherein the silicon single crystal is pulled while doping with carbon and controlling V/G (V: crystal pulling rate, G: crystal solid-liquid interface temperature gradient along a growing axis) to have an N-region over the entire plane of the crystal in which the silicon single crystal is grown in accordance with Czochralski method.

As described above, by doping with carbon, the single crystal having the N-region can be pulled faster than a single crystal in the case of not doping with carbon, and improvement of productivity of the silicon single crystal having no grown-in defect and decrease in cost can be achieved.

In this case, the silicon single crystal can be doped with nitrogen as well as carbon in which the CZ silicon single crystal is grown.

As described above, by doping with nitrogen as well as carbon, a pulling rate to become the N-region in the crystal is increased and the N-region can be expanded, so that productivity and yield of the silicon single crystal having the N-region over the entire plane of the crystal can be improved simultaneously.

In this case, the silicon single crystal is preferably pulled while doping with carbon having concentration of 0.1 ppma or more and controlling V/G within a range of from 0.183 to 0.177 mm²/K·min.

By this method, the silicon single crystal having the N-region over the entire plane of the crystal can be certainly produced more stable at a high speed.

Further, there is provided the method for producing a silicon wafer according to the present invention, wherein the silicon single crystal produced by the above method is processed into wafers, and the wafers are subjected to heat treatment at a temperature of from 600 to 1000°C.

As described above, the crystal doped with carbon, or carbon and nitrogen is processed in to wafers, and the wafers are subjected to heat treatment at a temperature of from 600 to 1000°C. Because the wafers are doped with carbon, the formation of oxygen precipitation nuclei at a low temperature in a bulk is accelerated and the wafer having the N-region over the entire surface and having high-level IG ability in the wafer plane can be produced.

The silicon wafer according to the present invention contains carbon of 0.1 ppma or more and has the N-region over the entire plane.

As described above, the wafer contains carbon of 0.1 ppma or more so that stable oxygen precipitation nuclei at a low temperature are increased to become the silicon wafer having the N-region over the entire plane and having sufficient IG ability.

In this case, the silicon wafer according to the present invention preferably contains nitrogen of 1 x 10¹³ number/cm³ or more.

As described above, the silicon wafer contains both nitrogen and carbon, so that it becomes the silicon wafer having sufficiently high-density BMD even if subjected to high temperature heat treatment or low temperature heat treatment in a moderate oxygen concentration and having extremely high IG ability.

There is provided the method for producing a silicon epitaxial wafer according to the present invention which is formed an epitaxial layer on a surface of a silicon wafer produced from a CZ silicon single crystal pulled with doping with carbon and nitrogen in which the CZ silicon single crystal is grown, wherein the CZ silicon single crystal is pulled to have carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively.

As described above, in order to obtain a silicon wafer used for a substrate of the epi-wafer, a single crystal is pulled with doping with carbon, nitrogen and oxygen of which concentrations of carbon, nitrogen and oxygen are within above ranges, respectively so that the wafer is produced from the single crystal having sufficient IG ability and having no secondary defects, and can be formed an epitaxial layer thereon. As the result, a high quality epi-wafer can be easily obtained.

Further, an epi-wafer according to the present invention is a silicon epitaxial wafer formed an epitaxial layer on a surface of a silicon wafer produced from a CZ silicon single crystal pulled with doping with carbon and nitrogen in which the CZ silicon single crystal is grown, wherein the silicon wafer has carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively.

The epi-wafer, which is produced from the wafer controlled each concentration of carbon, nitrogen and oxygen within above ranges, used as a substrate and formed an epi-layer thereon, becomes a extremely high quality epitaxial wafer having no secondary defects on its substrate and thereby having excellent crystallinity of the epi-layer formed thereon, and having a high IG ability.

Additionally, there is provided the method for producing an annealed wafer according to the present invention, which the wafer is formed a denuded zone in a surface layer of a CZ silicon wafer and having oxide precipitates of 1 x 10⁹ number/cm³ or more in a bulk portion by performing a heat treatment to the CZ silicon wafer produced from a CZ silicon single crystal pulled with doping with carbon and nitrogen in which the CZ silicon single crystal is grown, wherein the CZ silicon single crystal is pulled to have carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively.

As described above, in order to obtain a silicon wafer used as a base wafer of the annealed wafer, a single crystal is pulled with doping with carbon and nitrogen of which concentrations of carbon, nitrogen and oxygen are within above ranges respectively in accordance with CZ method. As the result, the annealed wafer having sufficient BMD density and having no generation of secondary defects can be easily obtained.

Furthermore, there is provided an annealed wafer according to the present invention which is produced by performing a heat treatment to a CZ silicon wafer having carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma respectively, wherein BMD density in a bulk portion is 1 x 10⁹ number/cm³ or more.

As described above, the annealed wafer, which is produced from the silicon wafer controlled each concentration of carbon, nitrogen and oxygen within above ranges and heat-treated thereto, is a high quality wafer having sufficient high-density BMD and high IG ability and having few defects on the wafer surface and no secondary defects and having excellent crystallinity.

As described above, according to the present invention, a single crystal having no generation of secondary defects in the entire N-region plane and having high IG ability can be pulled at a high pulling rate. Therefore, productivity and yield of such a CZ silicon single crystal can be improved, and its production cost can be reduced drastically. Further, oxygen precipitation can be stably obtained without dependence on a crystal position or device process, so that a CZ silicon wafer having little unevenness of density of oxide precipitate and stable gettering ability can be obtained. Furthermore, the CZ silicon wafer according to the present invention having proper concentration ranges of carbon, nitrogen and oxygen is produced so that an epitaxial wafer not annihilating oxygen precipitation, even when high temperature epitaxial growth is performed on its surface, and having excellent crystallinity and high IG ability can be produced. Similarly, if such a CZ silicon wafer is subjected to heat treatment, an annealed wafer forming a denuded zone in its surface layer portion and having sufficiently high density BMD in its bulk portion can be produced, and the wafer is extremely suitable for a high integrated device.

### Best Mode for Carrying out the Invention

The embodiment of present invention will be explained in detail hereinafter, but the present invention is not limited thereto.

The present inventors have conceived that not only nitrogen but also carbon are doped in order to accelerate oxygen precipitation in a bulk portion, and conducted investigation and examination about this.

### (In relation to N-region wafer)

First, the affection of carbon doping on an N-region wafer was investigated.

When a CZ silicon single crystal having a diameter of 8 inches was grown, carbon was doped to be incorporated carbon of about 0.1 ppma into the crystal, a CZ silicon single crystal pulling apparatus was set with HZ (Hot Zone: furnace structure) possible to grow an entire N-region wafer, and the crystal was pulled while gradually changing a pulling rate of from 0.8 to 0.5 mm/min (without nitrogen doping).

As the result, in the case of not doping with carbon, OSF ring was disappeared at the pulling rate of 0.54 mm/min, and defects due to dislocation loop were generated at the pulling rate of 0.52 mm/min. On the contrary, in the case of doping with carbon, OSF ring was disappeared at the pulling rate of 0.65 mm/min, and defects due to dislocation loop were generated at the pulling rate of 0.63 mm/min. In other words, it was found that the N-region was obtained at a higher pulling speed by doping with carbon. In this case, V/G range was 0.183-0.177 mm²/K·min. It means that productivity of entire N-region wafers can be improved by doping with carbon. However, when the carbon concentration is exceeded 3 ppma, it is concerned about harmful affection on device characteristics, and therefore the carbon concentration is preferably 3 ppma or less.

It has generally known that the N-region has two categories that are mixed in, one is an N (V) region, which is placed in a V-rich region side predominated vacancy type defects, and the other is an N (I) region, which is placed in an I-rich region side predominated interstitial silicon and having defects due to dislocation of loop, and these two regions have different amount of precipitated oxygen each other (see Japanese Patent Application No. 11-322242). Namely, it suffers from a problem that IG ability varies depending on the position in a wafer plane or a sliced position from a crystal.

The same was observed in a nitrogen-doped crystal. However, it has been confirmed by another examination (see Japanese Patent Application No. 2000-48461) that formation of oxygen precipitation nuclei at low temperature (600-1000°C) is accelerated in the case of doping with carbon. A wafer with carbon doping is subjected to such a low temperature heat treatment so that the difference of precipitation between N (V) region and N (I) region can be practically eliminated. This indicates that the entire N-region wafer with carbon doping has a high level of stable IG ability in the entire wafer plane.

Next, the same experiment as described above was conducted except that the crystal was doped with nitrogen as well as carbon. As the result, a pulling rate possible to obtain the N-region was increased and expanded. Nitrogen inherently has expansion effect of the N-region, but does not have the effect to increase a pulling rate possible to obtain the N-region. This experiment indicates that by doping with the two dopants, both productivity and yield of the entire N-region wafer can be improved simultaneously. Further, because the effect for oxygen precipitation was also remarkably obtained, stable oxygen precipitation nuclei in a high temperature were increased under the effect of nitrogen and stable oxygen precipitation nuclei in a low temperature were also increased under the effect of carbon. This indicates that the acceleration effect of oxygen precipitation is very strong in various temperature ranges. Therefore, even if any heat treatment is performed in a device process, high IG ability can be shown. In this regard, in order to surely obtain the effect of nitrogen, its concentration requires 1 x 10¹⁰ number/cm³ or more, and in order not to hinder single-crystallization, the concentration is preferably 5 x 10¹⁵ number/cm³ or less.

In consideration of these experimental findings, in order to obtain a crystal having the same effect on a long range of the crystal this time by employing the same HZ as the above experiment, first, the crystal was pulled at the range of pulling rate of from 0.65 to 0.62 mm/min with doping with carbon and nitrogen to be the concentrations of 0.1 ppma and 3 x 10¹³ atom/cm³, respectively. As a result, the crystal had the N-region in the lower position of from the top (seed crystal side) of the crystal to the straight body of 20 cm. After a wafer sliced from the crystal was subjected to heat treatment at 600°C for one hour to accelerate the formation of oxygen precipitation nuclei, the wafer was subjected to heat treatment of 800°C/4Hr + 1000°C/16Hr to grow oxide precipitates and observed by OPP (Optical Precipitate Profiler) method. There existed BMD having the density of 1 x 10⁹ number/cm³ or more in a bulk on the entire plane of the wafer.

### (In relation to epitaxial wafer)

Next, in relation to a silicon wafer for epitaxial growth, the affection of carbon and nitrogen doping on a BMD density was conducted investigation and experiment.

In the case where the nitrogen concentration exceeds 1 x 10¹⁴ number/cm³, OSF region tends to expand widely and LEP tends to generate easily. Therefore, first, the crystal was pulled with doping with nitrogen to be the concentration of 5 x 10¹³ number/cm³, and doping with carbon to be the concentration of 0.1 ppma. After a wafer sliced from the crystal was subjected to heat treatment of 800°C/4Hr + 1000°C/16Hr to be actualized oxide precipitates, and its BMD density was observed by OPP method.

As a result, it was found that BMD density strongly depended on initial interstitial oxygen concentration in the wafer, and unless the oxygen concentration was 15 ppma (Japan Electronic Industry Development Association (JEIDA) Standard) or more, BMD density was not generated in the 10⁹. However, as for this nitrogen concentration (5 x 10¹³ number/cm³), secondary defects generated due to nitrogen doping are hardly generated, and stable oxygen precipitation nuclei are formed at the high temperature (1000°C or more), so that even if a high temperature epitaxial growth is performed, oxygen precipitation nuclei is not annihilated. Therefore, as described above, even if the nitrogen concentration is 5 x 10¹³ number/cm³ and the carbon concentration is low concentration (0.01 ppma), but the initial interstitial oxygen concentration is 15 ppma or more, the silicon wafer for epitaxial growth having sufficient BMD density and no secondary defects can be obtained. If oxygen concentration is 15 ppma or more, a necessary and sufficient BMD density can be obtained when nitrogen concentration is 1 x 10¹³ or more. However, if oxygen concentration exceeds 25 ppma, oxide precipitates are over-precipitated and that affects wafer strength. Therefore, the oxygen concentration is preferably 25 ppma or less. In this regard, in order to enhance the oxygen precipitation effect by carbon, it is preferred that low temperature heat treatment of about 600-1000°C is preformed before epitaxial growth.

Continuously, in order to use high concentration of nitrogen (1 x 10¹⁴ number/cm³ or more), a sample of which initial interstitial oxygen concentration was lowered was prepared. As described above, even if nitrogen concentration was high, but oxygen concentration was less than 15 ppma, the generation of secondary defects can be suppressed. However, as the result, oxygen precipitation was actually difficult to generate (BMD density < 1 x 10⁹ number/cm³).

Accordingly, carbon concentration was increased up to 1.0 ppma. As the result, even when oxygen concentration was low oxygen of 12 ppma, BMD density after subjected to heat treatment of 800°C/4Hr + 1000°C/16Hr was in the first half of 10⁹. That is, in the case of this combination (nitrogen concentration of 1 x 10¹⁴ number/cm³ and carbon concentration of 1.0 ppma), if initial oxygen concentration is low oxygen, secondary defects are not generated and high BMD density can be obtained. However, when carbon concentration exceeds 3 ppma, that may have a harmful effect on characteristics of devices to be manufactured. Therefore, carbon concentration is preferably 3 ppma or less. Also, in order to obtain sufficient BMD, oxygen concentration requires 10 ppma or more. Regarding nitrogen concentration, in order not to hinder single-crystallization of a pulling crystal, the concentration is preferably 5 x 10¹⁵ number/cm³ or less. In this case, in order to increase the effect of oxygen precipitation by carbon, low temperature heat treatment of about 600-1000°C is also preferably performed before epitaxial growth.

On the contrary, in the case of the crystal having low carbon concentration (0.1 ppma) and high nitrogen concentration of 1 x 10¹⁴ number/cm³, in order to obtain sufficient BMD density (in the 10⁹), initial oxygen concentration can not be lowered less than 15 ppma, and as the result, secondary defects were generated after all.

Further, in the case of the crystal having high carbon concentration (1.0 ppma) and low nitrogen concentration (5 x 10¹³ number/cm³), BMD density to be obtained unduly depends on the heat treatment temperature in the first stage due to the affection of high carbon concentration, so that unevenness of BMD density varies widely depending on the heat treatment temperature in the first stage. Accordingly, as expected, it is desirable that nitrogen of a certain degree of high concentration is doped to form stable oxygen precipitation nuclei in high temperature.

As described above, by doping with nitrogen of a certain degree of higher concentration (for example, 1 x 10¹⁴ number/cm³), dependence of heat treatment temperature in the first stage becomes weaker than the case of doping with only carbon, so that unevenness of BMD density due to heat treatment temperature in the first stage becomes less. However, by passing a process heat treatment of too much high temperature, precipitation accelerating effect due to carbon becomes weak considerably. Accordingly, it concludes that the temperature of an epiprocess to obtain high BMD density is desirably low temperature (1000°C or less).

In the same way, by performing low temperature heat treatment before or after an epitaxial process, growth of oxygen precipitation nuclei or formation of new precipitation nuclei can be accelerated much better, and therefore BMD density in the subsequent epitaxial growth or other device process becomes high.

In this regard, the heat treatment performed before or after an epitaxial process is not limited to such a low temperature heat treatment, and so-called IG heat treatment (including high temperature heat treatment of 1000°C or more in the first stage, for example) or high temperature and short time heat treatment through use of RTA apparatus (Rapid Thermal Annealer) can be applied. These heat treatment processes can reduce secondary defects generated in a wafer surface, so that the effect that the concentration ranges of carbon, nitrogen and oxygen can be widely selected can be obtained.

### (In relation to annealed wafer)

Finally, the affection of the crystal doped with carbon and nitrogen on an annealed wafer was conducted investigation and experiment.

In the case of an annealed wafer, in fundamentally the same investigation as in the case of above-described silicon wafer for epitaxial growth, the combinations of the concentrations of low carbon + low nitrogen + high oxygen and of high carbon + high nitrogen + low oxygen were also very effective to obtain high BMD density and to suppress secondary defects. Besides, even if secondary defects were generated in a wafer surface, the secondary defects could be also annihilated by annealing. Accordingly, it was found that unlike the case where the epitaxial growth was directly performed, the annealed wafer having sufficient BMD density and few defects in the wafer surface could be obtained by the combinations of the concentrations of low carbon + high nitrogen + high oxygen and of high carbon + high nitrogen + high oxygen. It was further found that even if an epitaxial layer was formed on such an annealed wafer, defects were not generated in the epitaxial layer and sufficient BMD density could be obtained.

In this regard, in order to make use of carbon characteristics, by further performing low temperature heat treatment or suppressing a heating rate at 5°C/min or less during annealing, precipitation nuclei could also be increased. According to these processes, it was observed that BMD density of from the last half of the 10⁹ to the 10¹⁰ could be secured after the heat treatment of 800°C/4Hr + 1000°C/16Hr.

As described above, by doping with both carbon and nitrogen, they can work as counteracting each disadvantage of carbon and nitrogen, so that sufficient BMD density in various device processes can be gained more than the case of doping with only carbon or only nitrogen.

Table 1 shows the summary of the above-described experimental results about nitrogen and carbon doped wafers used for an epitaxial wafer and annealed wafer.

**Table 1**

| Carbon concentration | Low (0.1 ppma) | | | | High (1.0 ppma) | | | |
|---|---|---|---|---|---|---|---|---|
| Nitrogen concentration | Low (5E13 number/cm³) | | High (1E14 number/cm³) | | Low (5E13 number/cm³) | | High (1E14 number/cm³) | |
| Oxygen concentration | Low <15ppma | High **≧** 15 ppma | Low <15ppma | High ≧ 15ppma | Low <15ppma | High ≧ 15ppma | Low < 15ppma | High ≧ 15ppma |
| Secondary Defects | Not generated | Not generated | Not generated | Generated | Not generated | Not generated | Not generated | Generated |
| BMD Density | Low <1E9/cm³ | High ≧ 1E9/cm³ | Low <1E9/cm³ | High ≧ 1E9/cm³ | Heat treatment dependence is High | Heat Treatment dependence is High | High ≧ 1E9/cm³ | High ≧ 1E9/cm³ |
| For Epi-growth | Unsuitable | Suitable | Unsuitable | Unsuitable | Suitable only when adding low temperature heat treatment | Suitable Only when adding low temperature heat treatment | Suitable | Unsuitable |
| For Anneal | Unsuitable | Suitable | Unsuitable | Suitable (Secondary defects can be disappeared by anneal) | Suitable only when adding low temperature heat treatment | Suitable Only when adding low temperature heat treatment | Suitable | Suitable (Secondary defects can be disappeared by anneal) |

The present invention is not limited to the embodiments described above. The above-described embodiments are mere examples, and those having the substantially same structure as that described in the appended claims and providing the similar functions and advantages are included in the scope of the present invention.

For example, while the aforementioned embodiments were explained for the growth of silicon single crystals having a diameter of 8 inches, the present invention is not limited thereto, and can be applied to a silicon single crystal having a diameter of 6 inches or less, or from 10 to 16 inches or more.

## Claims

1. A method for producing a silicon single crystal, wherein a silicon single crystal is pulled while doping with carbon and controlling V/G (V: crystal pulling rate, G: crystal solid-liquid interface temperature gradient along a growing axis) to have an N-region over an entire plane of the crystal in which the silicon single crystal is grown in accordance with Czochralski method.

2. The method for producing a silicon single crystal according to claim 1, wherein the silicon single crystal is doped with nitrogen as well as carbon in which the CZ silicon single crystal is grown.

3. The method for producing a silicon single crystal according to claims 1 or 2, wherein the silicon single crystal is pulled while doping with carbon having concentration of 0.1 ppma or more and controlling V/G within a range of from 0.183 to 0.177 mm²/K·min.

4. A method for producing a silicon single crystal, wherein the silicon single crystal produced by the method according to any one of claims 1 to 3 is processed into wafers, and the wafers are subjected to heat treatment at a temperature of from 600 to 1000°C.

5. A silicon wafer, which contains carbon of 0.1 ppma or more and has an N-region over an entire plane thereof.

6. The silicon wafer according to claim 5, which contains nitrogen of 1 x 10¹³ number/cm³ or more.

7. A method for producing a silicon epitaxial wafer formed an epitaxial layer on a surface of a silicon wafer produced from a CZ silicon single crystal pulled with doping with carbon and nitrogen in which the CZ silicon single crystal is grown, wherein the CZ silicon single crystal is pulled to have carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively.

8. The method for producing a silicon epitaxial wafer according to claim 7, wherein the CZ silicon single crystal is pulled not to generate secondary defects.

9. A silicon epitaxial wafer formed an epitaxial layer on a surface of a silicon wafer produced from a CZ silicon single crystal pulled with doping with carbon and nitrogen in which the CZ silicon single crystal is grown, wherein the silicon wafer has carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively.

10. The silicon epitaxial wafer according to Claim 9, wherein a silicon wafer produced from the CZ silicon single crystal pulled with doping with nitrogen has no secondary defects.

11. A method for producing an annealed wafer formed a denuded zone in a surface layer of a CZ silicon wafer and having oxide precipitates of 1 x 10⁹ number/cm³ or more in a bulk portion by performing a heat treatment to the CZ silicon wafer produced from a CZ silicon single crystal pulled with doping with carbon and nitrogen in which the CZ silicon single crystal is grown, wherein the CZ silicon single crystal is pulled to have carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively.

12. The method for producing an annealed wafer according to claim 11, wherein the CZ silicon single crystal is pulled not to generate secondary defects.

13. An annealed wafer produced by performing a heat treatment to a CZ silicon wafer having carbon concentration, nitrogen concentration and oxygen concentration of from 0.1 to 1 ppma, from 1 x 10¹³ to 1 x 10¹⁴ number/cm³ and from 15 to 25 ppma, respectively, or from 1 to 3 ppma, from 1 x 10¹⁴ to 5 x 10¹⁵ number/cm³ and from 10 to 15 ppma, respectively, wherein BMD density in a bulk portion is 1 x 10⁹ number/cm³ or more.

14. The annealed wafer according to claim 13, wherein the wafer has no secondary defects.
